(19) **Europäisches Patentamt / European Patent Office / Office européen des brevets**

(11) **EP 3 596 849 B1**

(12) **FASCICULE DE BREVET EUROPEEN**

(45) Date de publication et mention
de la délivrance du brevet:
**25.11.2020 Bulletin 2020/48**

(51) Int Cl.:
**H04B 14/00** (2006.01)   **G01S 13/82** (2006.01)
**G01S 13/75** (2006.01)   **H03C 5/00** (2006.01)

(21) Numéro de dépôt: **18706759.0**

(22) Date de dépôt: **28.02.2018**

(86) Numéro de dépôt international:
**PCT/EP2018/054855**

(87) Numéro de publication internationale:
**WO 2018/166790 (20.09.2018 Gazette 2018/38)**

(54) **DISPOSITIF DE MODULATION D'UN SIGNAL HYPERFREQUENCE, TRANSPONDEUR COMPORTANT UN TEL DISPOSITIF, ET BALISE REPONDEUSE EQUIPEE D'UN TEL TRANSPONDEUR**

VORRICHTUNG ZUM MODULIEREN EINES MIKROWELLENSIGNALS, TRANSPONDER MIT SOLCH EINER VORRICHTUNG UND ANTWORTBAKE MIT SOLCH EINEM TRANSPONDER

DEVICE FOR MODULATING A MICROWAVE SIGNAL, TRANSPONDER INCLUDING SUCH A DEVICE, AND RESPONDER BEACON EQUIPPED WITH SUCH A TRANSPONDER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.03.2017 FR 1700264**

(43) Date de publication de la demande:
**22.01.2020 Bulletin 2020/04**

(73) Titulaire: **Thales**
**92400 Courbevoie (FR)**

(72) Inventeurs:
• **GARREC, Patrick**
  **33700 Merignac (FR)**
• **DESPOISSE, Thibaut**
  **33700 Merignac (FR)**
• **GHIOTTO, Anthony**
  **33405 Talence cedex (FR)**

(74) Mandataire: **Marks & Clerk France**
**Immeuble "Visium"**
**22, avenue Aristide Briand**
**94117 Arcueil Cedex (FR)**

(56) Documents cités:
**WO-A1-92/14307     WO-A2-01/29574**

**Description**

La présente invention concerne un dispositif de modulation d'un signal hyperfréquence, un transpondeur comportant un tel dispositif et une balise répondeuse équipée d'un tel transpondeur. Le domaine de l'invention est notamment celui de la localisation de cibles, en mouvement ou immobiles, au moyen de balises répondeuses.

Pour cette localisation, on est amené à utiliser des transpondeurs, par exemple pour la détection d'objets en mouvement ou de vitesse sensiblement nulle comme par exemple un hélicoptère en vol stationnaire notamment. Dans ce contexte, un problème à résoudre est de réaliser des transpondeurs à faible coût offrant de bonnes performances.

Pour réaliser des transpondeurs, les solutions de l'art antérieur utilisent des systèmes non linéaires, notamment des mélangeurs hyperfréquences. Ils mettent en œuvre des modulations d'amplitude ou de phase. Le transpondeur réémet ainsi un signal reçu avec une modulation d'amplitude ou une modulation de phase. A cette fin, une première entrée d'un mélangeur reçoit le signal reçu par le transpondeur et une deuxième entrée reçoit le signal de modulation, le signal modulé étant obtenu en sortie du mélangeur. Ce type de modulation au moyen de mélangeurs entraîne des raies d'harmoniques suite aux découpages non linéaires effectués sur le signal comme le montre la modulation d'amplitude décrite ci-après.

On considère un signal CW(t) reçu par le transpondeur, ce signal est continu, d'amplitude A, de fréquence $f_1$ et de déphasage $\phi_1$, il a la forme suivante :

$$CW(t) = A.\sin(2\pi f_1 t + \varphi_1)$$

Le signal de modulation m(t) est un carré d'amplitude 1, de fréquence $f_2$ et de rapport cyclique 50%. Il s'agit en fait d'une modulation de type OOK (« On Off Keying »), il est caractérisé par l'équation :

$$m(t) = signe(\sin(2\pi f_2 t))$$

Le résultat de la modulation, en sortie du mélangeur, est :

$$s(t) = CW(t) * m(t) = A.\sin(2\pi f_1 t + \varphi_1) * signe(\sin(2\pi f_2 t))$$

Les spectres des signaux *CW(t), m(t)* sont respectivement :

$$Tf\big(CW(t)\big) = \widehat{CW}(f) = \frac{A}{2i}(\delta(f - f_1) - \delta(f + f_1))$$

$$\begin{aligned}Tf\big(m(t)\big) &= \widehat{m}(f)\\ &= \frac{4}{\pi}.Tf\left(\sin(2\pi.f_2.t) + \frac{1}{3}\sin(3 * 2\pi.f_2.t)\right.\\ &\left.+ \frac{1}{5}\sin(5 * 2\pi.f_2.t) + ...\right)\end{aligned}$$

*Tf* étant la transformée de Fourier et $\delta$ étant la fonction de Dirac.

Le spectre de s(t) est donc composé de la porteuse et des raies harmoniques impaires d'amplitudes décroissantes.

Ce type de modulation est simple à faire, mais laisse la fréquence fondamentale et les harmoniques, donc des rayonnements non essentiels et de l'énergie rétrodiffusée inutilement. Il est alors nécessaire d'adjoindre des filtres étroits pour éliminer ces raies d'harmoniques.

A titre d'exemple, le document WO2012151056 décrit un système utilisant des mélangeurs et des modulateurs d'amplitudes et donc des filtres. De même le document FR3002098 divulgue un transpondeur utilisant obligatoirement un mélangeur et des filtres.

Une modulation de phase, de type PSK par exemple, est également simple à mettre en œuvre. Dans ce cas la fréquence fondamentale est supprimée, mais les harmoniques demeurent. Il en est de même pour les modulations de phases sinusoïdales. Elle ne supprime pas les harmoniques et il faut ajouter des filtres très complexes pour supprimer ces dernières.

Un document WO 92/14307 A1 divulgue un procédé de réalisation d'une boucle fermée de synchronisation pour établir une communication bidirectionnelle entre un répondeur et un interrogateur, dans lequel on peut utiliser différentes fréquences de communication entre l'interrogateur et le répondeur.

Finalement, tous ces systèmes non linéaires sont complexes et coûteux à mettre en œuvre, ils sont volumineux et nécessitent par ailleurs des calibrations.

Un but de l'invention est notamment de réaliser des transpondeurs à faibles coûts, simples à mettre en œuvre et performants. A cet effet, l'invention a notamment pour objet un dispositif de modulation d'un signal hyperfréquence comportant au moins :

- un circuit de génération d'un signal sinusoïdal redressé ;
- un circuit de déphasage apte à recevoir en entrée ledit signal hyperfréquence comportant :

    o une première voie appliquant un déphasage donné ;
    o une deuxième voie appliquant ledit déphasage donné augmenté de $\pi$ ;

- un amplificateur à gain variable dont le gain est commandé par ledit signal sinusoïdal redressé ;
- un commutateur commandé par ledit signal sinusoïdal redressé, apte à aiguiller alternativement ladite première voie et ladite deuxième voie en entrée dudit amplificateur, la commutation d'une voie à l'autre étant effectuée à chaque passage à 0 dudit signal sinusoïdal redressé, le signal de sortie dudit amplificateur étant le signal hyperfréquence modulé.

Ledit dispositif comporte par exemple :

- un deuxième circuit de génération d'un signal sinusoïdal redressé ;
- un deuxième amplificateur à gain variable dont le gain est commandé par ledit signal sinusoïdal redressé généré par ledit deuxième circuit;
- un deuxième commutateur commandé par ledit signal sinusoïdal redressé, apte à aiguiller alternativement ladite première voie et ladite deuxième voie en entrée dudit deuxième amplificateur, la commutation d'une voie à l'autre étant effectuée à chaque passage à 0 dudit signal sinusoïdal redressé ;
- un additionneur sommant le signal de sortie dudit premier amplificateur et le signal de sortie dudit deuxième amplificateur ;

le signal en sortie dudit additionneur, résultant de la somme desdits signaux de sortie étant le signal modulé.

Un déphaseur est par exemple connecté entre ledit deuxième commutateur et ledit deuxième amplificateur à gain variable, ledit appliquant un déphasage de $+\pi/2$, ledit signal modulé étant à bande latérale unique.

Ledit déphasage donné est par exemple nul. Ladite première voie relie par exemple l'entrée dudit circuit de déphasage à une première entrée dudit commutateur, ladite deuxième voie comportant un déphaseur appliquant un déphasage de $\pi$ connecté entre ladite entrée et une deuxième entrée dudit commutateur.

Ledit déphasage donné est par exemple égal à $-\pi/2$. Dans un exemple de réalisation :

- ladite première voie comporte un premier déphaseur appliquant un déphasage de $-\pi/2$ connecté entre l'entrée dudit circuit de déphasage et une première entrée dudit commutateur ;

- ladite deuxième voie comporte un deuxième déphaseur appliquant un déphasage de $+\pi/2$ connecté entre ladite entrée et une deuxième entrée dudit commutateur.

Dans un autre mode de réalisation possible, un dispositif selon l'invention comporte au moins :

- un circuit de génération d'un premier signal sinusoïdal et d'un deuxième signal sinusoïdal déphasé de $\pi$ par rapport audit premier signal ;
- une première voie, apte à recevoir en entrée ledit signal hyperfréquence, comportant un premier déphaseur appliquant un déphasage donné et un premier amplificateur à gain variable dont le gain est commandé par ledit premier signal sinusoïdal ;
- une deuxième voie, apte à recevoir en entrée ledit signal hyperfréquence, comportant un deuxième déphaseur appliquant ledit déphasage donné augmenté de $\pi$ et un deuxième amplificateur à gain variable dont le gain est commandé par ledit deuxième signal sinusoïdal;
- un additionneur sommant le signal de sortie dudit premier amplificateur et le signal de sortie dudit deuxième amplificateur ;

le signal en sortie dudit additionneur résultant de la somme desdits signaux de sortie étant le signal modulé.

Ledit déphasage donné est par exemple nul ou encore égal à -π/2.

Ledit circuit de génération comporte par exemple au moins un générateur basse fréquence délivrant ledit signal sinusoïdal et un circuit à amplificateur différentiel reproduisant d'une part ledit signal sinusoïdal pour former ledit premier signal sinusoïdal et délivrant d'autre part un signal sinusoïdal déphasé de π par rapport audit signal sinusoïdal pour former ledit deuxième signal sinusoïdal.

L'invention a également pour objet un transpondeur comportant au moins :

- des moyens de réception aptes à recevoir un signal hyperfréquence ;

- un dispositif de modulation selon l'un des modes de réalisation décrits précédemment, modulant le signal issu dudit circuit de réception ;

- des moyens d'émission apte à émettre le signal modulé en sortie dudit dispositif de modulation.

Lesdits moyens de réception comportant une antenne composée d'un réseau d'éléments rayonnants, ledit déphasage de π entre ladite première voie et ladite deuxième voie est par exemple obtenu au niveau des éléments rayonnants entre la polarité positive et la polarité négative de chaque élément rayonnant, la première voie étant connectée à l'ensemble des polarités positives et la deuxième voie étant connectée à l'ensemble des polarités négatives.

L'invention a encore pour objet une balise répondeuse équipée d'un transpondeur tel que décrit précédemment, ladite sinusoïde redressée ou lesdits signaux sinusoïdaux ayant par exemple une fréquence sensiblement égale à 1 kHz.

D'autres caractéristiques et avantages de l'invention apparaîtront à l'aide de la description qui suit, faite en regard de dessins annexés qui représentent :

- La figure 1, un premier exemple de réalisation d'un transpondeur selon l'invention ;
- Les figures 2a et 2b présentant respectivement l'allure du signal réémis en sortie du transpondeur et du spectre de ce signal ;
- La figure 3, un deuxième exemple de réalisation d'un transpondeur selon l'invention ;
- La figure 4, un exemple de réalisation d'un transpondeur selon l'invention effectuant une double modulation d'un signal reçu ;
- La figure 5, un exemple de réalisation pour un autre mode de modulation effectuée dans un transpondeur selon l'invention ;
- La figure 6, un exemple de réalisation de circuits de déphasage utilisés pour la modulation ;
- La figure 7, un exemple d'application d'une modulation selon l'invention à une émission de type BLU : bande latérale unique.

On décrit par la suite un transpondeur incorporant un dispositif de modulation selon l'invention. Comme le montreront les exemples de réalisations décrits, la modulation d'un signal hyperfréquence selon l'invention consiste notamment :

- à amplifier un signal hyperfréquence déphasé d'un angle donné selon l'amplitude d'un premier signal sinusoïdal, pour obtenir un premier signal amplifié et ;
- à amplifier ce même signal hyperfréquence déphasé de l'angle donné augmenté de π selon l'amplitude un deuxième signal sinusoïdal, égal au premier signal déphasé de π, pour obtenir un deuxième signal amplifié déphasé de π par rapport au premier signal amplifié ;

Le signal hyperfréquence modulé est une combinaison du premier signal amplifié et du deuxième signal amplifié.

Deux modes de réalisation sont décrits par la suite pour réaliser cette modulation. Le premier mode de réalisation utilise un amplificateur à gain variable pour amplifier les signaux selon l'amplitude d'une sinusoïde redressée et un commutateur pour reconstituer une fonction équivalente aux deux sinusoïdes. Le deuxième mode de réalisation utilise deux amplificateurs à gain variable, sans commutateur.

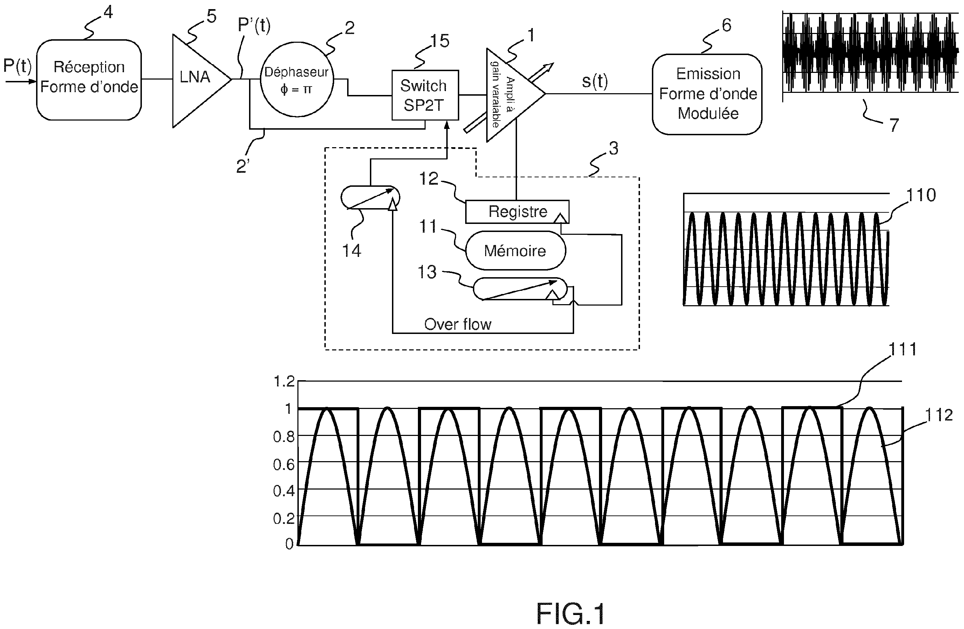

La figure 1 illustre donc un premier exemple de réalisation d'un transpondeur selon l'invention. Il comporte avantageusement un circuit réalisant une modulation du signal reçu.

Le signal reçu P(t) et la modulation M(t) sont définis selon la relation suivante :

$$\text{Signal reçu : } P(t) = N.\sin(2\pi.f_1.t + \varphi)$$

$$\text{Modulation } M(t) = N_1.\sin(2\pi.f_2.t + \varphi_1)$$

Le signal modulé s(t), réémis par le transpondeur est, au déphasage près :

$$s(t) = P(t).M(t) = N_1.\sin(2\pi.f_2.t).N.\sin(2\pi.f_1.t) \tag{1}$$

Bien sûr le signal reçu peut aussi être une rampe de fréquence variant en fonction du temps.

Pour mettre en œuvre cette multiplication et donc appliquer la modulation, le circuit utilise notamment un amplificateur à gain variable 1, un déphaseur 2, un commutateur 15 et un circuit de commande 3 pour générer la fréquence de base de la modulation $\omega_2 = 2\pi.f_2$.

Le transpondeur comporte par exemple des moyens de réception 4 captant le signal P(t). Ces moyens de réception sont réalisés de façon connue, ils comportent au moins une antenne de réception et les circuits associés dirigeant le signal reçu P(t) vers les autres circuits du transpondeur, par exemple vers un amplificateur faible bruit 5 dont le signal de sortie est noté P'(t)

Le signal de sortie de l'amplificateur est modulé selon la relation (1) ci-dessus au moyen de l'amplificateur à gain variable 1, du déphaseur 2, du commutateur 15 et du circuit de commande 3. Plus précisément, un circuit de déphasage est formé d'une première voie comprenant le déphaseur 2, reliée en sortie de ce déphaseur à une entrée du commutateur, et d'une deuxième voie 2' reliée directement à une autre entrée du commutateur. Le commutateur 15 et l'amplificateur forment un circuit amplifiant alternativement un signal issu de la première voie et un signal issu de la deuxième voie.

La sortie de l'amplificateur 1 délivre le signal modulé s(t), ce dernier étant réémis par des moyens d'émission 6. Ces derniers comportent au moins un amplificateur de puissance et une antenne d'émission, cette dernière pouvant également être utilisée en réception.

Pour réaliser la fonction $N_1.\sin(2\pi.f_1.t)$, le circuit de commande comporte une mémoire 11 dans laquelle est stockée une sinusoïde redressée 110 sous forme échantillonnée, représentant la valeur absolue de la fonction $N_1.\sin(2\pi\omega_1 t)$. Les échantillons de sinusoïde 110 défilent dans un registre 12 à la cadence d'un premier compteur 13. La valeur affichée sur le registre commande le gain de l'amplificateur 1 de sorte que le gain de ce dernier suit la fonction sinus redressée 110. L'amplitude de la sinusoïde redressée 110 est fonction de la dynamique du gain d'amplificateur de sorte que ce dernier amplifie son signal entrant selon l'amplitude $N_1$ souhaitée de la fonction sinus.

Pour obtenir la multiplication du signal reçu P(t) par la fonction $N_1.\sin(2\pi.f_1.t)$ (sinusoïde complète) en sortie de l'amplificateur faible bruit 5, le transpondeur utilise le déphaseur 2. Ce dernier effectue un déphase de $\pi$ sur le signal P(t). En combinaison avec le circuit de commande, il réalise un déphasage de $\pi$ une demi-sinusoïde sur deux sur le signal P(t), le signal P(t) n'étant pas déphasé l'autre demi-période (déphasage égal à 0). Ce déphase $0-\pi$ appliqué sur le signal reçu, en combinaison avec le gain d'amplificateur suivant la fonction $| N_1.\sin(2\pi.f_1.t) |$ conduit à multiplier le signal reçu par la fonction $N_1.\sin(2\pi.f_1.t)$.

Pour commander ce déphasage $0-\pi$, le circuit de commande comporte un deuxième compteur 14 commandant le commutateur 15. Ce compteur 14, synchronisé sur le premier compteur, compte la durée des demi-sinusoïdes. A chaque nouvelle demi-sinusoïde, le deuxième compteur 14 commande le commutateur 15 qui est par exemple de type SP2T.

Ce commutateur comporte :

- une entrée reliée à la sortie du déphaseur 2, laissant donc passer le signal P(t) déphasé de $\pi$ ;
- une deuxième entrée reliée directement en sortie de l'amplificateur faible bruit 5, et laissant passer le signal P(t) non déphasé.

La sortie du commutateur est reliée à l'entrée de l'amplificateur à gain variable 1. L'une ou l'autre des entrées est commutée vers cette sortie à la cadence du deuxième compteur 14, c'est-à-dire à chaque nouvelle demi-sinusoïde.

La figure 1 présente, en dessous du circuit de commande 3, la fonction sinusoïde redressée 112 commandant le gain de l'amplificateur 1. Cette fonction sinusoïde redressée 112 est déterminée par la demi-sinusoïde mémorisée 110 et la cadence de déroulement de cette dernière par le premier compteur 13 qui détermine sa fréquence. Appliquée en combinaison avec le déphasage de $\pi$, elle correspond à la fonction de modulation M(t) ci-dessus.

Sur le même graphique, est également représentée la commande de déphasage 111 effectuée par le deuxième

**EP 3 596 849 B1**

compteur 14. Ce dernier délivre une valeur 1 et une valeur 0, chacune de ces valeurs aiguillant l'une ou l'autre entrée du commutateur vers sa sortie. Il en résulte que l'une ou l'autre voie du circuit de déphasage 2, 2' est aiguillée alternativement vers l'amplificateur à gain variable, la commutation d'une voie à l'autre se faisant par le passage à 0 du signal sinusoïdal redressé.

La figure 1 présente un exemple de réalisation du circuit de commande 3. Ce dernier délivre essentiellement la valeur absolue de la modulation, c'est-à-dire | M(t) |. D'autres modes de réalisation peuvent être mis en œuvre pour réaliser la même fonction. Le circuit tel que représenté peut être remplacé par toute autre forme de circuit logique ou programmable, ou encore par un microcontrôleur.

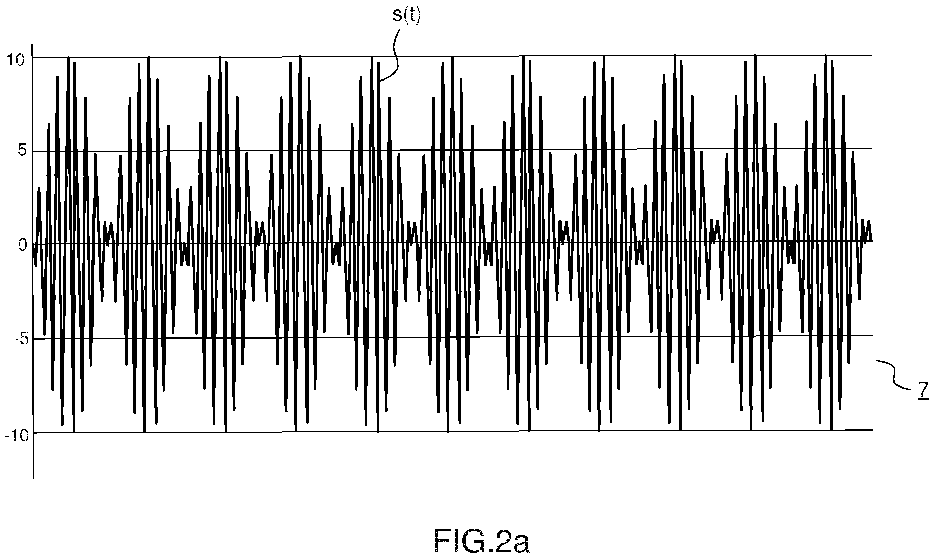

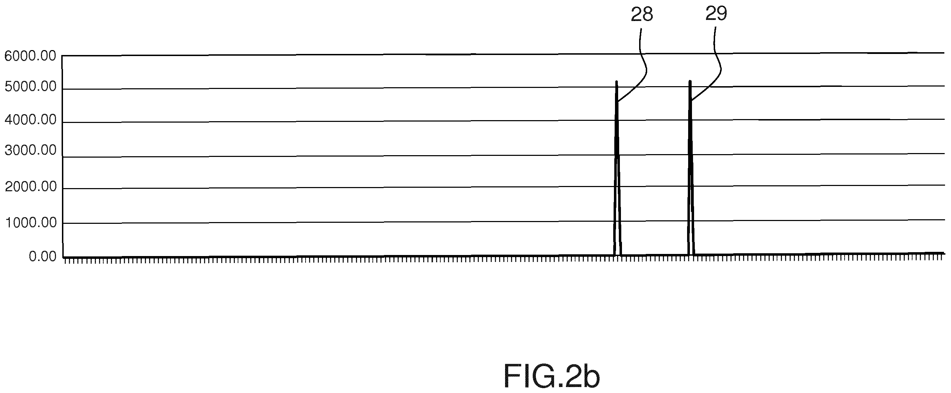

Les figures 2a et 2b illustrent respectivement le signal 7 réémis par le transpondeur en sortie des moyens d'émissions 6, modulé selon le dispositif de la figure 1, et le spectre de ce signal.

La figure 2a montre bien que le signal de sortie 7 est sans porteuse, sa modulation dépendant de la fréquence $f_1$ de modulation appliquée par le circuit de commande 3.

Le signal reçu P(t) est modulé à une fréquence plus basse selon une enveloppe définie par la demi-sinusoïde 112, ou sinusoïde redressée, de la figure 1. La fréquence $f_1$ de modulation est par exemple sensiblement égale à 1 KHz.

La figure 2b montre les deux raies spectrales 28, 29 du signal de sortie 7 représentatives de la fonction sinus. Il n'y a pas de raies harmoniques.

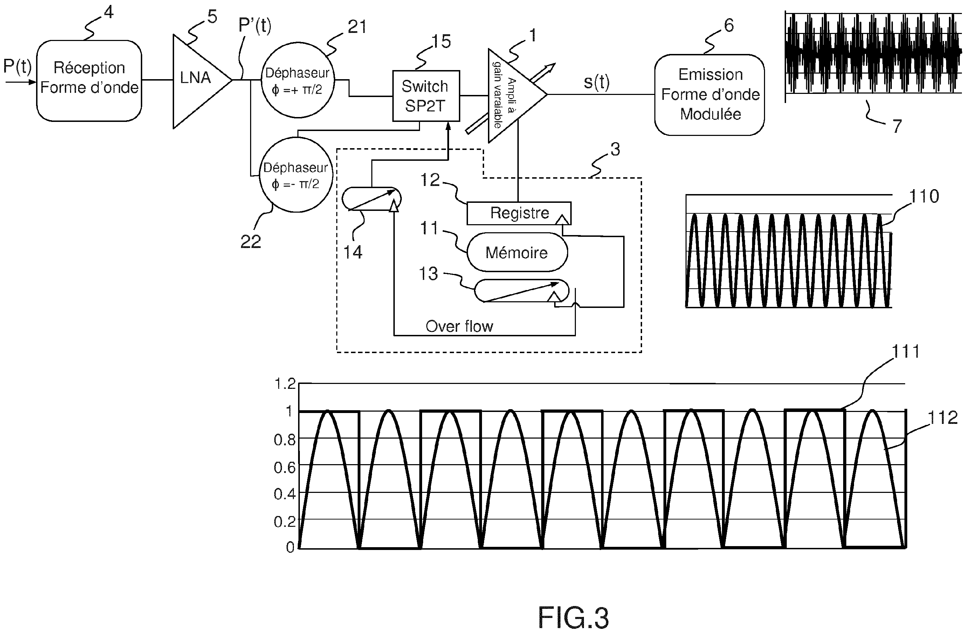

La figure 3 illustre un autre exemple de réalisation d'un transpondeur selon l'invention où le déphaseur de π est avantageusement remplacé par deux déphaseurs 21, 22, un déphaseur 21 réalisant un déphasage de +π/2 sur la première voie du circuit de déphasage et l'autre déphaseur 22 réalisant un déphasage de - π/2 sur la deuxième voie.

Ces deux déphaseurs sont donc insérés entre l'amplificateur faible bruit 5 et le commutateur 15, la sortie d'un déphaseur étant reliée à une entrée du commutateur et la sortie de l'autre déphaseur étant reliée à l'autre entrée du commutateur. Comme dans l'exemple de réalisation de la figure 1, on obtient toujours un déphasage de π entre deux demi-sinusoïdes redressées consécutives reconstituant fonctionnellement une sinusoïde complète, tout en bénéficiant d'un meilleur équilibrage des signaux entre les deux voies d'entrée du commutateur 15.

Un autre avantage apporté par les exemples de réalisation des figures 1 et 3 est qu'ils permettent de traiter les signaux reçus dans une grande dynamique, en amplitude et en énergie. A titre de comparaison, lorsqu'on utilise un mélangeur, composant non linéaire, il faut amplifier le signal pour entrer dans la zone non linéaire de ce mélangeur. Cela limite la dynamique des signaux et oblige encore à ajouter des filtres pour supprimer les harmoniques. Dans le cas d'une modulation par une fréquence faible, il y a des harmoniques très proches de la porteuse du signal reçu P(t) et la réalisation des filtres apporte de nombreux désavantages, notamment en termes de coût, d'encombrement et de difficulté de mise en œuvre, notamment pour obtenir des filtres reconfigurables.

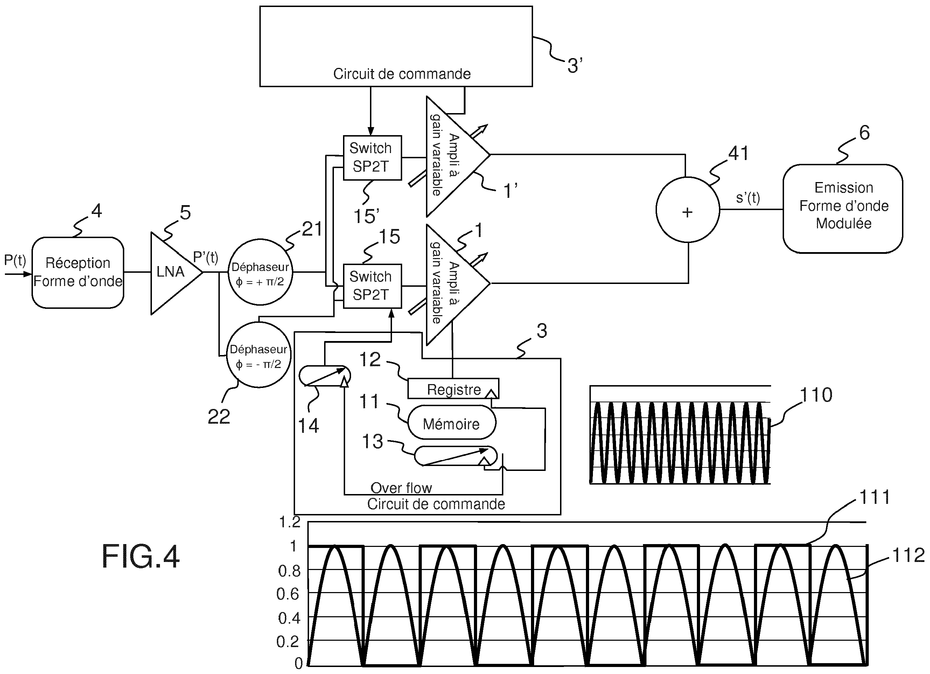

La figure 4 illustre un autre exemple possible de réalisation d'un transpondeur selon l'invention. Dans cet exemple, le transpondeur réalise une double modulation.

Pour réaliser cette double modulation, on double le circuit de commande 3, le commutateur 15 et l'amplificateur à gain variable 1, en partant par exemple du montage de la figure 3. Dans ce cas, les deux entrées d'un deuxième commutateur 15' sont connectées l'une au déphaseur +π/2, l'autre au déphaseur -π/2. La sortie de ce commutateur 15' est reliée à l'entrée d'un deuxième amplificateur à gain variable. Un deuxième circuit de commande 3', ayant la même structure et même fonction que le circuit de commande 3 des figures 1 et 3, commande le deuxième commutateur 15' et le gain de l'amplificateur comme décrit relativement à ces figures.

Les sorties de deux amplificateurs 1, 1' sont sommées par un circuit 41 pour fournir le signal modulé s'(t) qui est émis par les moyens d'amplification 6.

Avantageusement, la fréquence de modulation $f_1$ peut effectuer des sauts temporels, et donc de coder des données, permettant ainsi de réaliser une liaison de données à bas coût. Cette liaison peut être réalisée dans un montage simple ou à double modulation.

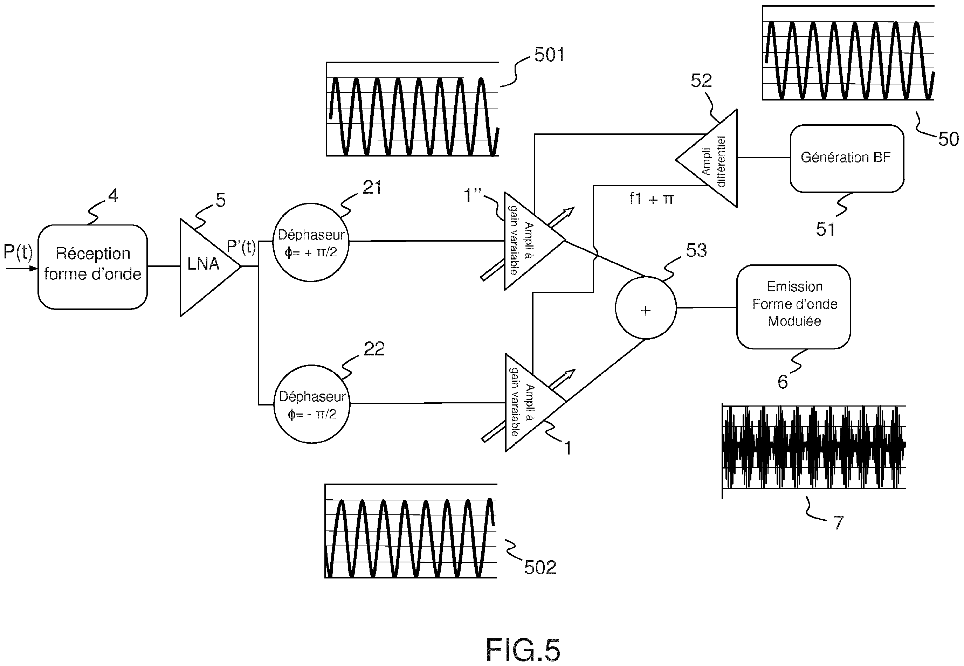

La figure 5 illustre un autre exemple de réalisation d'un transpondeur selon l'invention n'utilisant pas de commutateur. Dans ce cas, la modulation est commandée par un générateur de fréquence 51 et deux amplificateurs différentiels représentés en un seul amplificateur 52. Dans ce montage, un premier amplificateur est monté en mode inverseur et l'autre est monté en mode non inverseur. Le signal sinusoïdal issu du générateur 51 est transmis :

- en entrée de l'amplificateur différentiel non-inverseur, qui transmet ce signal à sa sortie ;
- et en entrée de l'amplificateur inverseur, qui transmet ce signal à sa sortie, inversé, c'est-à-dire avec un déphasage de π.

La réjection du mode commun de ce montage est effectuée selon des solutions connues.

Le transpondeur comporte toujours le circuit de réception 4, l'amplificateur 5 et les deux déphaseurs 21, 22 (+π/2, -π/2) en parallèle suivis chacun d'un amplificateur à gain variable 1, 1". Les signaux de sortie de ces derniers sont sommés 53 puis émis par les moyens d'émission 6.

Le générateur de fréquence 51 délivre la fréquence de modulation $f_1$ représentée par une courbe 50. Ce signal de modulation comme précédemment est de fréquence plus basse, par exemple égal à 1 kHz. Il est envoyé en entrée de l'amplificateur différentiel 52, composé des deux amplificateurs, inverseur et non-inverseur. Cet amplificateur 52 délivre en sortie un premier signal 501 à la fréquence $f_1$ et un deuxième signal inversé 502, c'est-à-dire déphasé de $\pi$. Le premier signal sinusoïdal 501 commande le gain variable d'un amplificateur 1 et le deuxième signal sinusoïdal 502 commande le gain variable de l'autre amplificateur 1".

En sortie de l'amplificateur faible bruit 5, le signal reçu P(t) est dirigé vers les deux déphaseurs 21, 22. Il est déphasé de $+\pi/2$ par le premier déphaseur 21 et de $-\pi/2$ par le deuxième déphaseur 22. Les signaux résultants ainsi déphasés de $\pi$ entrent dans les amplificateurs à gain variable 1, 1" commandés en opposition de phase. Ils sont amplifiés suivant les sinusoïdes 501, 502 puis additionnés par un additionneur 53. Le signal en sortie de cet additionneur est le même signal 7 que celui obtenu au moyen du commutateur 15 et de l'amplificateur 1 du circuit de la figure 3, selon l'enveloppe de modulation résultant de la somme des sinusoïdes 501, 502.

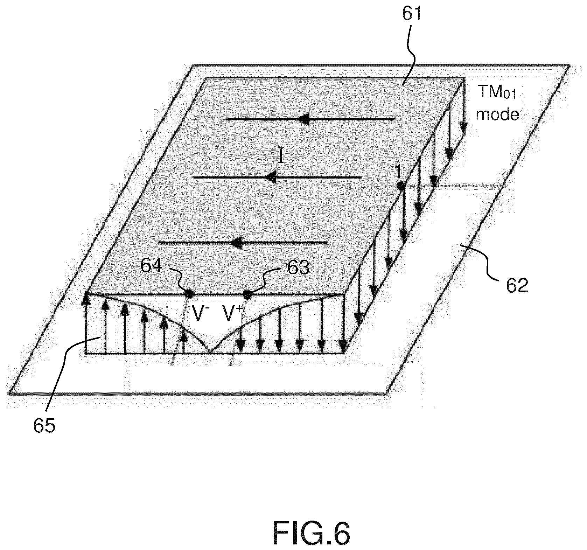

La figure 6 illustre un mode de réalisation particulier du déphasage du signal reçu. Dans ce cas, on exploite l'architecture globale du transpondeur et notamment la structure des moyens de réception 4, et notamment de l'antenne de réception. La figure 6 correspond au cas où l'antenne de réception est une antenne constituée d'un réseau d'éléments rayonnants, encore appelés patchs. La figure 6 présente un de ces éléments rayonnants.

Le signal de réception induit un champ électromagnétique 65 entre la face métallisée 61 de l'élément rayonnant et son plan de masse 62 se propageant selon le mode $TM_{01}$ dans l'exemple de la figure 6. Dans cette configuration, les ports de sortie de l'élément rayonnant 63, 64 sont l'un à une tension V+(t) et l'autre à une tension V-(t) qui sont naturellement en opposition de phase par construction de l'élément rayonnant, comme l'illustre la direction du champ électromagnétique 65.

Avantageusement, l'invention utilise ces ports de sortie 63, 64 pour créer le déphasage. Une telle solution simplifie l'architecture du transpondeur, car elle supprime les déphaseurs 21, 22 réalisant les déphasages $+\pi/2$ et $-\pi/2$. A cette fin, en se référant par exemple au montage de la figure 3, les sorties du port 63, V+(t), de tous les éléments rayonnants sont reliées sur la première entrée du commutateur 15, et les sorties du port 64, V-(t), de tous les éléments rayonnants sont reliées sur la deuxième entrée du commutateur. En se référant à la figure 5, les liaisons se feraient vers le premier amplificateur à gain variable 1 et vers le deuxième amplificateur à gain variable 1".

Cette solution a également comme avantage de présenter en permanence un déphasage constant de $\pi$ entre les sorties, quelle que soit la fréquence du signal reçu. Ceci n'est pas le cas des déphaseurs qui sont rarement parfaits sur une large bande de fréquence.

Avantageusement, un transpondeur tel que décrit selon les modes de réalisation précédents peut équiper une balise répondeuse. Une telle balise peut être réalisée à bas coût grâce à l'utilisation de ce transpondeur. Il est également avantageusement possible de faire apparaître des raies décalées en fréquence très près du signal reçu, sans la porteuse, par exemple à 1 kHz d'un signal reçu à 10 GHz.

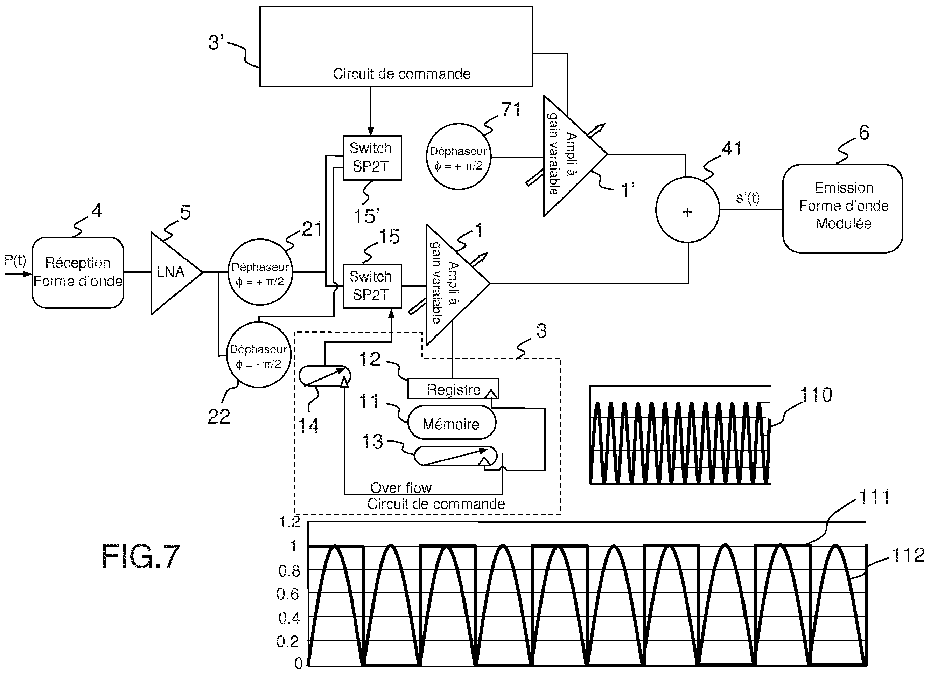

La figure 7 illustre un exemple de réalisation d'un dispositif de modulation à bande latérale unique (BLU), à partir de l'exemple de réalisation de la figure 4. Une modulation BLU est une modulation d'amplitude dans laquelle la porteuse est supprimée, ainsi que l'une des bandes latérales.

La solution selon l'invention, supprimant la porteuse, permet avantageusement de réaliser une modulation de type BLU.

Dans l'art antérieur, les dispositifs à BLU utilisent un filtrage et un modulateur d'amplitude, non linéaire, apportant des harmoniques.

En effet, ce que l'on cherche à faire traditionnellement avec un modulateur BLU est d'obtenir :
V(t) = U.S.$\cos(2\pi(f_1 + f_2).t)$ (BLU supérieure) ou V(t) = U.S.$\cos(2\pi(f_1 - f_2).t)$ (BLU inférieure) à partir de :

- s(t) = S.$\cos(2\pi.f_1.t)$ sur une première entrée du modulateur et ;
- u(t) = U.$\cos(2\pi.f_2.t)$ sur une deuxième entrée du modulateur.

Cette façon de faire nécessite un filtrage et un modulateur, non linéaire, apportant des harmoniques.

Sachant que :

- $\cos(a+b) = \cos a \cos b - \sin a \sin b$, on obtient la BLU supérieure ;
- $\cos(a-b) = \cos a \cos b + \sin a \sin b$, on obtient la BLU inférieure ;
- $\sin(a + \pi/2) = \cos(a)$ ;
- $\cos(-a) = \cos(a)$ ;
- $\sin(-a) = -\sin(a)$.

On obtient la BLU supérieure et la BLU inférieure, en particulier :
$\sin(a).\sin(b) + \cos(a).\cos(b) = \cos(a-b)$ pour la BLU inférieure Pour la BLU supérieure, il faut mettre en œuvre :

$$\sin(a).\sin(b) - \cos(a).\cos(b) = -\cos(a+b)$$

Pour la BLU inférieure, notée $S_{blu}(t)$, en reprenant les notations précédentes, $V(t) = S_{blu}(t)$ est égale à :

$$K.\cos(2\pi.f_1.t + 2\pi.f_2.t) = K.(\cos(2\pi.f_1.t).\cos(2\pi.f_2.t) + \sin(2\pi.f_1.t).\sin(2\pi.f_2.t)).$$

La première voie de modulation du circuit de la figure 4, composé des deux modulateurs 21, 22, du premier commutateur 15 et du premier amplificateur à gain variable 1 permet de réaliser le terme du produit en sinus, c'est-à-dire $\sin(2\pi.f_1.t).\sin(2\pi.f_2.t)$.

On utilise avantageusement la deuxième voie de modulation pour effectuer le produit en cosinus, c'est-à-dire $\cos(2\pi.f_1.t).\cos(2\pi.f_2.t)$.

En effet, sachant que :

$$\cos(2\pi.f_2.t) = \sin(2\pi.f_2.t + \pi/2) \text{ et que } \cos(2\pi.f_1.t) = \sin(2\pi.f_1.t + \pi/2) ;$$

la mise en œuvre pour cette fonction devient similaire à la précédente, en introduisant un déphaseur de $\pi/2$ dans la deuxième voie de modulation. Ainsi, en partant du montage de la figure 4, on ajoute un déphaseur 71 dans la deuxième voie de modulation, par exemple entre le deuxième commutateur 15' et le deuxième amplificateur à gain variable 1'. Ce déphaseur supplémentaire applique un déphasage de $+ \pi/2$.

Le signal en sortie de l'additionneur 41 forme le signal modulé à BLU.

Comme le montre les exemples de réalisation décrits précédemment, l'invention permet avantageusement d'émettre une modulation sinusoïdale en éliminant la porteuse, sans générer d'harmonique et tout en n'utilisant pas de filtres. Elle permet également d'avoir des modulations très proches de la porteuse.

Un autre avantage est la possibilité de miniaturiser fortement le dispositif de modulation, et par là même de diminuer l'encombrement d'une balise qui l'intègre ainsi que son coût.

L'invention permet aussi avantageusement de faire une modulation multifréquences, cette modulation pouvant être utilisée pour une application de télécommunication. On peut en effet utiliser un même circuit de commande pour commander deux, voire plus de fonctions de translation fréquentielle et donc utiliser ce moyen pour faire de la transmission de données.

**Revendications**

1. Dispositif de modulation d'un signal hyperfréquence (P(t)), comportant au moins :

   - un circuit (3) de génération d'un signal sinusoïdal redressé (110, 112) ;
   - un circuit (2, 2', 21, 22) de déphasage apte à recevoir en entrée ledit signal hyperfréquence comportant :

      o une première voie appliquant un déphasage donné (2', 22) ;
      o une deuxième voie (2, 21) appliquant ledit déphasage donné augmenté de $\pi$ ;

   - un amplificateur à gain variable (1) dont le gain est commandé par ledit signal sinusoïdal redressé ;
   - un commutateur (15) commandé par ledit signal sinusoïdal redressé, apte à aiguiller alternativement ladite première voie et ladite deuxième voie en entrée dudit amplificateur, la commutation d'une voie à l'autre étant effectuée à chaque passage à 0 dudit signal sinusoïdal redressé, le signal de sortie (s(t)) dudit amplificateur étant le signal hyperfréquence modulé.

2. Dispositif selon la revendication 1, **caractérisé en ce qu'**il comporte :

   - un deuxième circuit (3') de génération d'un signal sinusoïdal redressé ;
   - un deuxième amplificateur à gain variable (1') dont le gain est commandé par ledit signal sinusoïdal redressé généré par ledit deuxième circuit (3') ;
   - un deuxième commutateur (15') commandé par ledit signal sinusoïdal redressé, apte à aiguiller alternativement ladite première voie et ladite deuxième voie en entrée dudit deuxième amplificateur, la commutation d'une voie à l'autre étant effectuée à chaque passage à 0 dudit signal sinusoïdal redressé ;
- un additionneur (41) sommant le signal de sortie dudit premier amplificateur (1) et le signal de sortie dudit deuxième amplificateur (1') ;

le signal en sortie dudit additionneur (53), résultant de la somme desdits signaux de sortie étant le signal modulé.

3.  Dispositif selon la revendication 2, **caractérisé en ce qu'**il comporte un déphaseur (71) entre ledit deuxième commutateur (15') et ledit deuxième amplificateur à gain variable (1'), ledit déphaseur (71) appliquant un déphasage de $+\pi/2$, ledit signal modulé étant à bande latérale unique.

4.  Dispositif selon l'une quelconque des revendications précédentes, **caractérisé en ce que** ledit déphasage donné est nul.

5.  Dispositif selon la revendication 4, **caractérisé en ce que** ladite première voie relie (2') l'entrée dudit circuit de déphasage à une première entrée dudit commutateur (15), ladite deuxième voie comportant un déphaseur (2) appliquant un déphasage de $\pi$ connecté entre ladite entrée et une deuxième entrée dudit commutateur (15).

6.  Dispositif selon l'une quelconque des revendications précédentes, **caractérisé en ce que** ledit déphasage donné est égal à $-\pi/2$.

7.  Dispositif selon la revendication 6, **caractérisé en ce que** :

    - ladite première voie comporte un premier déphaseur (22) appliquant un déphasage de $-\pi/2$ connecté entre l'entrée dudit circuit de déphasage et une première entrée dudit commutateur (15) ;
    - ladite deuxième voie comporte un deuxième déphaseur (21) appliquant un déphasage de $+\pi/2$ connecté entre ladite entrée et une deuxième entrée dudit commutateur (15).

8.  Dispositif de modulation d'un signal hyperfréquence (P(t)), comportant au moins :

    - un circuit (51, 52) de génération d'un premier signal sinusoïdal (501) et d'un deuxième signal sinusoïdal (502) déphasé de $\pi$ par rapport audit premier signal (501) ;
    - une première voie, apte à recevoir en entrée ledit signal hyperfréquence, comportant un premier déphaseur (21) appliquant un déphasage donné et un premier amplificateur à gain variable (1") dont le gain est commandé par ledit premier signal sinusoïdal (501) ;
    - une deuxième voie, apte à recevoir en entrée ledit signal hyperfréquence, comportant un deuxième déphaseur (22) appliquant ledit déphasage donné augmenté de $\pi$ et un deuxième amplificateur à gain variable (1) dont le gain est commandé par ledit deuxième signal sinusoïdal (501) ;
    - un additionneur (53) sommant le signal de sortie dudit premier amplificateur (1") et le signal de sortie dudit deuxième amplificateur (1) ;

    le signal en sortie dudit additionneur (53) résultant de la somme desdits signaux de sortie étant le signal modulé.

9.  Dispositif selon la revendication 8, **caractérisé en ce que** ledit déphasage donné est nul.

10. Dispositif selon la revendication 8, **caractérisé en ce que** ledit déphasage donné est égal à $-\pi/2$.

11. Dispositif selon l'une quelconque des revendications 8 à 10, **caractérisé en ce que** ledit circuit de génération comporte au moins un générateur basse fréquence (51) délivrant ledit signal sinusoïdal (50) et un circuit à amplificateur différentiel (52) reproduisant d'une part ledit signal sinusoïdal pour former ledit premier signal sinusoïdal (501) et délivrant d'autre part un signal sinusoïdal déphasé de $\pi$ par rapport audit signal sinusoïdal pour former ledit deuxième signal sinusoïdal (502).

12. Transpondeur, **caractérisé en ce qu'**il comporte au moins :

    - des moyens de réception (4, 5) aptes à recevoir un signal hyperfréquence ;
    - un dispositif de modulation selon l'une quelconque des revendications précédentes, modulant le signal issu dudit circuit de réception ;
    - des moyens d'émission (6) apte à émettre le signal modulé en sortie dudit dispositif de modulation.

13. Transpondeur selon la revendication 12, **caractérisé en ce que** lesdits moyens de réception (4) comportant une antenne composée d'un réseau d'éléments rayonnants, ledit déphasage de π entre ladite première voie et ladite deuxième voie est obtenu au niveau des éléments rayonnants entre la polarité positive (63) et la polarité négative (64) de chaque élément rayonnant, la première voie étant connectée à l'ensemble des polarités positives et la deuxième voie étant connectée à l'ensemble des polarités négatives.

14. Balise répondeuse, **caractérisée en ce qu'**elle est équipée d'un transpondeur selon l'une quelconque des revendications 12 ou 13.

15. Balise répondeuse selon la revendication 14, **caractérisée en ce que** ladite sinusoïde redressée (110, 112) ou lesdits signaux sinusoïdaux sont sensiblement à la fréquence de 1 kHz.

**Patentansprüche**

1. Vorrichtung zum Modulieren eines Mikrowellensignals (P(t)), mindestens Folgendes umfassend:

   - einen Schaltkreis (3) zur Erzeugung eines gleichgerichteten sinusförmigen Signals (110, 112);
   - einen Schaltkreis (2, 2', 21, 22) zur Phasenverschiebung, welcher in der Lage ist, als Eingang das Mikrowellensignal aufzunehmen, Folgendes umfassend:

     o einen ersten Kanal, welcher eine gegebene Phasenverschiebung (2', 22) anlegt;
     o einen zweiten Kanal (2, 21), welcher die Phasenverschiebung erhöht um π anlegt;

   - einen Verstärker mit variabler Verstärkung (1), dessen Verstärkung durch das gleichgerichtete sinusförmige Signal gesteuert wird;
   - einen Umschalter (15), welcher durch das gleichgerichtete sinusförmige Signal gesteuert wird, in der Lage, alternativ den ersten Kanal und den zweiten Kanal am Eingang des Verstärkers umzuschalten, wobei die Umschaltung von einem Kanal zum anderen bei jedem Nulldurchgang des gleichgerichteten sinusförmigen Signals erfolgt, wobei das Ausgangssignal (s(t)) des Verstärkers das modulierte Mikrowellensignal ist.

2. Vorrichtung nach Anspruch 1, **dadurch gekennzeichnet, dass** sie Folgendes umfasst:

   - einen zweiten Schaltkreis (3') zur Erzeugung eines gleichgerichteten sinusförmigen Signals;
   - einen zweiten Verstärker mit variabler Verstärkung (1'), dessen Verstärkung durch das durch den zweiten Schaltkreis (3') erzeugte gleichgerichtete sinusförmige Signal gesteuert wird;
   - einen zweiten Umschalter (15'), welcher durch das gleichgerichtete sinusförmige Signal gesteuert wird, in der Lage, alternativ den ersten Kanal und den zweiten Kanal am Eingang des zweiten Verstärkers umzuschalten, wobei die Umschaltung von einem Kanal zum anderen bei jedem Nulldurchgang des gleichgerichteten sinusförmigen Signals erfolgt;
   - einen Summierer (41), welcher das Ausgangssignal des ersten Verstärkers (1) und das Ausgangssignal des zweiten Verstärkers (1') summiert;

   wobei das Ausgangssignal des Summierers (53), welches aus der Summe der Ausgangssignale resultiert, das modulierte Signal ist.

3. Vorrichtung nach Anspruch 2, **dadurch gekennzeichnet, dass** sie einen Phasenverschieber (71) zwischen dem zweiten Umschalter (15') und dem zweiten Verstärker mit variabler Verstärkung (1') umfasst, wobei der Phasenverschieber (71) eine Phasenverschiebung von + π/2 anlegt, wobei das modulierte Signal ein Einseitenband-Signal ist.

4. Vorrichtung nach einem der vorhergehenden Ansprüche, **dadurch gekennzeichnet, dass** die gegebene Phasenverschiebung gleich null ist.

5. Vorrichtung nach Anspruch 4, **dadurch gekennzeichnet, dass** der erste Kanal (2') den Eingang des Phasenverschiebungsschaltkreises mit einem ersten Eingang des Umschalters (15) verbindet, wobei der zweite Kanal einen Phasenverschieber (2) umfasst, welcher eine Phasenverschiebung um π anlegt, welcher zwischen dem Eingang und einem zweiten Eingang des Umschalters (15) verbunden ist.

**6.** Vorrichtung nach einem der vorhergehenden Ansprüche, **dadurch gekennzeichnet, dass** die gegebene Phasenverschiebung gleich - $\pi/2$ ist.

**7.** Vorrichtung nach Anspruch 6, **dadurch gekennzeichnet, dass**:

- der erste Kanal einen ersten Phasenverschieber (22) umfasst, welcher eine Phasenverschiebung von - $\pi/2$ anlegt, verbunden zwischen dem Eingang des Phasenverschiebungsschaltkreises und einem ersten Eingang des Umschalters (15);
- der zweite Kanal einen zweiten Phasenverschieber (21) umfasst, welcher eine Phasenverschiebung von + $\pi/2$ anlegt, verbunden zwischen dem Eingang und einem zweiten Eingang des Umschalters (15).

**8.** Vorrichtung zum Modulieren eines Mikrowellensignals (P(t)), mindestens Folgendes umfassend:

- einen Schaltkreis (51, 52) zur Erzeugung eines ersten sinusförmigen Signals (501) und eines zweiten sinusförmigen Signals (502), welches gegenüber dem ersten Signal (501) um $\pi$ phasenverschoben ist;
- einen ersten Kanal, welcher in der Lage ist, als Eingang das Mikrowellensignal aufzunehmen, umfassend einen ersten Phasenverschieber (21), welcher eine gegebene Phasenverschiebung anlegt, und einen ersten Verstärker mit variabler Verstärkung (1"), dessen Verstärkung durch das erste sinusförmige Signal (501) gesteuert wird;
- einen zweiten Kanal, welcher in der Lage ist, als Eingang das Mikrowellensignal aufzunehmen, umfassend einen zweiten Phasenverschieber (22), welcher die gegebene Phasenverschiebung erhöht um $\pi$ anlegt, und einen zweiten Verstärker mit variabler Verstärkung (1), dessen Verstärkung durch das zweite sinusförmige Signal (501) gesteuert wird;
- einen Summierer (53), welcher das Ausgangssignal des ersten Verstärkers (1") und das Ausgangssignal des zweiten Verstärkers (1) summiert;

wobei das Ausgangssignal des Summierers (53), welches aus der Summe der Ausgangssignale resultiert, das modulierte Signal ist.

**9.** Vorrichtung nach Anspruch 8, **dadurch gekennzeichnet, dass** die gegebene Phasenverschiebung gleich null ist.

**10.** Vorrichtung nach Anspruch 8, **dadurch gekennzeichnet, dass** die gegebene Phasenverschiebung gleich - $\pi/2$ ist.

**11.** Vorrichtung nach einem der Ansprüche 8 bis 10, **dadurch gekennzeichnet, dass** der Erzeugungsschaltkreis mindestens einen Niederfrequenzerzeuger (51) umfasst, welcher das sinusförmige Signal (50) abgibt, und einen Schaltkreis mit Differenzialverstärker (52), welcher einerseits das sinusförmige Signal reproduziert, um das erste sinusförmige Signal (501) zu bilden und andererseits ein um $\pi$ gegenüber dem sinusförmigen Signal phasenverschobenes sinusförmiges Signal abgibt, um das zweite sinusförmige Signal (502) zu bilden.

**12.** Transponder, **dadurch gekennzeichnet, dass** er mindestens Folgendes umfasst:

- Empfangsmittel (4, 5), welche in der Lage sind, ein Mikrowellensignal zu empfangen;
- eine Modulationsvorrichtung nach einem der vorhergehenden Ansprüche, welche das aus dem Empfangsschaltkreis stammende Signal moduliert;
- Sendemittel (6), welche in der Lage sind, das modulierte Signal am Ausgang der Modulationsvorrichtung auszusenden.

**13.** Transponder nach Anspruch 12, **dadurch gekennzeichnet, dass** die Empfangsmittel (4) eine aus einem Netzwerk von Abstrahlelementen gebildete Antenne umfassen, wobei die Phasenverschiebung um $\pi$ zwischen dem ersten Kanal und dem zweiten Kanal auf Höhe der Abstrahlelemente zwischen der positiven Polarität (63) und der negativen Polarität (64) eines jeden Abstrahlelements erzielt wird, wobei der erste Kanal mit sämtlichen positiven Polaritäten verbunden ist und der zweite Kanal mit sämtlichen negativen Polaritäten verbunden ist.

**14.** Antwortbake, **dadurch gekennzeichnet, dass** sie mit mindestens einem Transponder nach einem der Ansprüche 12 oder 13 ausgerüstet ist.

**15.** Antwortbake nach Anspruch 14, **dadurch gekennzeichnet, dass** die gleichgerichtete Sinuswelle (110, 112) oder die sinusförmigen Signale im Wesentlichen die Frequenz 1 kHz aufweisen.

**Claims**

1. A device for modulating a microwave signal (P(t)), comprising at least:

   - a circuit (3) for generating a rectified sinusoidal signal (110, 112);
   - a phase shifting circuit (2, 2', 21, 22) capable of receiving said microwave signal as input and comprising:

     o a first channel applying a given phase shift (2', 22);
     o a second channel (2, 21) applying said given phase shift enhanced by $\pi$;

   - a variable gain amplifier (1), the gain of which is controlled by said rectified sinusoidal signal;
   - a switch (15) controlled by said rectified sinusoidal signal, capable of alternately switching said first channel and said second channel at the input of said amplifier, the switching from one channel to the other being carried out upon each transition to 0 of said rectified sinusoidal signal, the output signal (s(t)) of said amplifier being the modulated microwave signal.

2. The device as claimed in claim 1, **characterised in that** it comprises:

   - a second circuit (3') for generating a rectified sinusoidal signal;
   - a second variable gain amplifier (1'), the gain of which is controlled by said rectified sinusoidal signal generated by said second circuit (3');
   - a second switch (15') controlled by said rectified sinusoidal signal, capable of alternately switching said first channel and said second channel at the input of said second amplifier, the switching from one channel to the other being carried out upon each transition to 0 of said rectified sinusoidal signal;
   - an adder (41) adding the output signal of said first amplifier (1) and the output signal of said second amplifier (1');

   the output signal of said adder (53), resulting from the sum of said output signals, being the modulated signal.

3. The device as claimed in claim 2, **characterised in that** it comprises a phase shifter (71) between said second switch (15') and said second variable gain amplifier (1'), said phase shifter (71) applying a phase shift of + $\pi/2$, said modulated signal being a single-sideband signal.

4. The device as claimed in any one of the preceding claims, **characterised in that** said given phase shift is zero.

5. The device as claimed in claim 4, **characterised in that** said first channel (2') connects the input of said phase shifting circuit to a first input of said switch (15), said second channel comprising a phase shifter (2) applying a phase shift of $\pi$ connected between said input and a second input of said switch (15).

6. The device as claimed in any one of the preceding claims, **characterised in that** said given phase shift is equal to - $\pi/2$.

7. The device as claimed in claim 6, **characterised in that**:

   - said first channel comprises a first phase shifter (22) applying a phase shift of -$\pi/2$ connected between the input of said phase shifting circuit and a first input of said switch (15);
   - said second channel comprises a second phase shifter (21) applying a phase shift of + $\pi/2$ connected between said input and a second input of said switch (15).

8. A device for modulating a microwave signal (P(t)), comprising at least:

   - a circuit (51, 52) for generating a first sinusoidal signal (501) and a second sinusoidal signal (502) phase shifted by $\pi$ relative to said first signal (501);
   - a first channel, capable of receiving said microwave signal as input, comprising a first phase shifter (21) applying a given phase shift and a first variable gain amplifier (1"), the gain of which is controlled by said first sinusoidal signal (501);
   - a second channel, capable of receiving said microwave signal as input, comprising a second phase shifter (22) applying said given phase shift enhanced by $\pi$ and a second variable gain amplifier (1), the gain of which is controlled by said second sinusoidal signal (501);
   - an adder (53) adding the output signal of said first amplifier (1") and the output signal of said second amplifier (1);

the output signal of said adder (53), resulting from the sum of said output signals, being the modulated signal.

9. The device as claimed in claim 8, **characterised in that** said given phase shift is zero.

10. The device as claimed in claim 8, **characterised in that** said given phase shift is equal to - $\pi$/2.

11. The device as claimed in any one of claims 8 to 10, **characterised in that** said generation circuit comprises at least one low-frequency generator (51) delivering said sinusoidal signal (50) and a differential amplifier circuit (52) reproducing, on the one hand, said sinusoidal signal to form said first sinusoidal signal (501) and delivering, on the other hand, a sinusoidal signal phase shifted by $\pi$ relative to said sinusoidal signal to form said second sinusoidal signal (502).

12. A transponder, **characterised in that** it comprises at least:

   - reception means (4, 5) capable of receiving a microwave signal;
   - a modulation device as claimed in any one of the preceding claims, modulating the signal originating from said reception circuit;
   - transmission means (6) capable of transmitting the modulated signal at the output of said modulation device.

13. The transponder as claimed in claim 12, **characterised in that** said reception means (4) comprise an antenna formed by an array of radiating elements, said phase shift of $\pi$ between said first channel and said second channel is obtained on the radiating elements between the positive polarity (63) and the negative polarity (64) of each radiating element, the first channel being connected to all the positive polarities and the second channel being connected to all the negative polarities.

14. A transponder beacon, **characterised in that** it is equipped with a transponder as claimed in any one of claims 12 or 13.

15. The transponder beacon as claimed in claim 14, **characterised in that** said rectified sinusoidal signal (110, 112) or said sinusoidal signals are substantially at the frequency of 1 kHz.

FIG.1

FIG.2a

FIG.2b

EP 3 596 849 B1

FIG.3

EP 3 596 849 B1

FIG.4

FIG.5

EP 3 596 849 B1

FIG.6

FIG.7

EP 3 596 849 B1

**EP 3 596 849 B1**

**Documents brevets cités dans la description**

- WO 2012151056 A
- FR 3002098
- WO 9214307 A1